(19) Europäisches Patentamt
European Patent Office
Office européen des brevets

(11) **EP 4 379 821 B1**

(12) **FASCICULE DE BREVET EUROPEEN**

(45) Date de publication et mention
de la délivrance du brevet:
**14.05.2025   Bulletin 2025/20**

(21) Numéro de dépôt: **23212433.9**

(22) Date de dépôt: **27.11.2023**

(51) Classification Internationale des Brevets (IPC):
**H01L 31/11** (2006.01)       **H01L 31/0216** (2014.01)

(52) Classification Coopérative des Brevets (CPC):
**H10F 30/24; H10F 77/306**

(54) **DÉMODULATEUR PHOTONIQUE ASSISTÉ PAR COURANT À PERFORMANCES AMELIORÉES COMPORTANT DES ÉLECTRODES INTERMÉDIAIRES**

STROMUNTERSTÜTZTER PHOTONISCHER DEMODULATOR MIT VERBESSERTER LEISTUNG UND ZWISCHENELEKTRODEN

CURRENT-ASSISTED PHOTONIC DEMODULATOR WITH IMPROVED PERFORMANCE COMPRISING INTERMEDIATE ELECTRODES

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:   **29.11.2022   FR 2212468**

(43) Date de publication de la demande:
**05.06.2024   Bulletin 2024/23**

(73) Titulaire: **Commissariat à l'Energie Atomique et aux Energies Alternatives 75015 Paris (FR)**

(72) Inventeurs:
• **ALIANE, Abdelkader**
  **38054 Grenoble cedex 09 (FR)**
• **KAYA, Hacile**
  **38054 Grenoble cedex 09 (FR)**
• **DURLIN, Quentin**
  **38054 Grenoble cedex 09 (FR)**
• **HARTMANN, Jean-Michel**
  **38054 Grenoble cedex 09 (FR)**
• **ANDRE, Luc**
  **38054 Grenoble cedex 09 (FR)**

(74) Mandataire: **Brevalex 22 Avenue Doyen Louis Weil 38000 Grenoble (FR)**

(56) Documents cités:
• **GIAN-FRANCO DALLA BETTA ET AL: "Design and Characterization of Current-Assisted Photonic Demodulators in 0.18- $\mu\hbox{m}$ CMOS Technology", IEEE TRANSACTIONS ON ELECTRON DEVICES, IEEE, USA, vol. 58, no. 6, 1 June 2011 (2011-06-01), pages 1702 - 1709, XP011323216, ISSN: 0018-9383, DOI: 10.1109/ TED.2011.2126578**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

Le domaine de l'invention est celui des démodulateurs photoniques assistés par courant (CAPD pour *Current-Assisted Photonic Demodulator,* en anglais) adaptés à détecter un rayonnement lumineux dans le proche infrarouge. L'invention trouve une application notamment dans la télémétrie, l'analyse biologique, et l'inspection industrielle (détection sans contact de défauts surfaciques).

**ÉTAT DE LA TECHNIQUE ANTÉRIEURE**

Les démodulateurs photoniques assistés par courant sont des photodétecteurs dans lesquels la distribution d'un champ électrique de dérive est modulée. Ils ont été décrits initialement notamment dans l'article scientifique de Van Nieuwenhove et al. intitulé Novel Standard CMOS Detector using Majority Current for giding Photo-Generated Electrons towards Detecting Junctions, Proc. Symp. IEEE/LEOS Benelux Chapter, pp. 229-232, 2005. Ce type de dispositif optoélectronique est particulièrement utilisé dans la télémétrie par mesure du temps de vol (TOF, pour *Time of Flight* en anglais).

Un tel démodulateur comporte habituellement une portion de détection en un matériau semiconducteur légèrement dopé de type p, qui présente, au niveau de l'une de ses faces, deux régions dopées p+ pour la génération d'un courant de dérive, ainsi que deux régions dopées n+ situées à proximité des régions dopées p+ pour la collection du photocourant. Une différence de potentiel électrique est appliquée entre les régions dopées p+, ce qui génère un champ électrique de dérive dans la portion de détection. Aussi, lorsque le rayonnement lumineux est absorbé dans la portion de détection, une paire électron-trou est générée, puis le trou photogénéré se propage sous l'effet du champ de dérive en direction de la région dopée p+ ayant le plus faible potentiel électrique, alors que l'électron photogénéré est dirigé en direction de la région dopée p+ opposée, puis est collecté par la région dopée n+ adjacente. Ainsi, le photocourant peut être mesuré efficacement par le démodulateur.

Du fait de la séparation entre le courant des trous majoritaires et le photocourant (électrons minoritaires), on limite ainsi la contribution du courant des trous majoritaires au bruit Schottky (*shot noise* en anglais) ainsi qu'au bruit thermique (*thermal noise* en anglais). Cependant, il existe un besoin d'améliorer les performances d'un tel démodulateur photonique assisté par courant.

**EXPOSÉ DE L'INVENTION**

L'invention a pour objectif de proposer un démodulateur photonique assisté par courant ayant des performances améliorées, notamment en termes de contraste de démodulation en AC, de sensibilité à la lumière parasite, et de bande passante. Un objectif secondaire est de proposer un démodulateur photonique adapté à détecter un rayonnement lumineux dans le proche infrarouge. Un autre objectif secondaire est de proposer une matrice de démodulateurs photoniques présentant un facteur de remplissage élevé.

Pour cela, l'objet de l'invention est un démodulateur photonique assisté par courant adapté à détecter un rayonnement lumineux d'intérêt. Il comprend :

- une portion de détection, s'étendant verticalement entre une première face et une deuxième face parallèles à un plan principal, et comportant : au moins deux régions dopées de type p, destinées à générer et à moduler un courant de dérive dans la portion de détection, affleurant la première face et situées de part et d'autre d'une zone centrale de la première face ; et au moins deux régions dopées de type n, adaptées à collecter les porteurs de charge minoritaires photogénérés lors de l'absorption du rayonnement lumineux d'intérêt dans la portion de détection, affleurant la première face et situées de manière adjacente aux régions dopées de type p ;
- une couche diélectrique de passivation, réalisée en un matériau électriquement isolant, et recouvrant la première face ;
- des électrodes de modulation, traversant la couche diélectrique de passivation et au contact des régions dopées de type p ; et des électrodes de collection, traversant la couche diélectrique de passivation et au contact des régions dopées de type n.

D'après l'invention, le démodulateur comporte également des électrodes intermédiaires, destinées à être polarisées négativement, traversant en partie la couche diélectrique de passivation et espacées de la première face d'une distance non nulle, chacune étant située, en projection dans le plan principal, entre l'une des régions dopées de type p et la région dopée de type n adjacente

Certains aspects préférés mais non limitatifs de ce démodulateur photonique sont les suivants.

Les électrodes intermédiaires peuvent être espacées de la première face d'une distance comprise entre 5nm et 50nm.

Les régions dopées de type p peuvent présenter une profondeur à partir de la première face supérieure à une profondeur des régions dopées de type n.

Les régions dopées de type p peuvent être situées, en projection dans le plan principal, à proximité de la zone centrale, et les régions dopées de type n en sont alors éloignées.

Les régions dopées de type p peuvent être des premières portions semiconductrices situées dans des premières échancrures de la portion de détection.

Les régions dopées de type n peuvent être des premières portions semiconductrices situées dans des deuxièmes échancrures de la portion de détection.

La portion de détection peut être réalisée à base de germanium.

Le démodulateur peut comporter une portion latérale périphérique entourant la portion de détection dans le plan principal, réalisée en un matériau semiconducteur à base de silicium.

La portion de détection peut comporter une zone latérale réalisée à base de SiGe, située à l'interface avec la portion latérale périphérique.

L'invention porte également sur un procédé de fabrication d'un démodulateur photonique selon l'une quelconque des caractéristiques précédentes, comportant les étapes suivantes :

- réalisation de la portion de détection en un matériau non intentionnellement dopé ;
- réalisation des régions dopées de type p et des régions dopées de type n dans la portion de détection ;
- dépôt d'une couche diélectrique de passivation sur la portion de détection ;
- réalisation des électrodes de modulation, des électrodes de collection, et des électrodes intermédiaires.

Les régions dopées de type p peuvent présenter une profondeur à partir de la première face supérieure à la profondeur des régions dopées de type n.

La réalisation des régions dopées de type p peut comporter les étapes suivantes :

- réalisation de premières échancrures dans la portion de détection à partir de la première face ;
- réalisation par épitaxie, dans les premières échancrures, de premières portions semiconductrices dopées de type p à la croissance.

La réalisation des régions dopées de type n peut comporter les étapes suivantes :

- réalisation de deuxièmes échancrures dans la portion de détection à partir de la première face ;
- réalisation par épitaxie, dans les deuxièmes échancrures, de deuxièmes portions semiconductrices dopées de type n à la croissance.

Les premières échancrures peuvent présenter une profondeur supérieure à la profondeur des deuxièmes échancrures.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1A, la figure 1B, et la figure 1C sont des vues schématiques et partielles, en coupe transversale, de démodulateurs photoniques assistés par courant selon différents modes de réalisation ;

la figure 2A, la figure 2B, et la figure 2C sont des vues schématiques et partielles, en vue de dessus, de démodulateurs photoniques assistés par courant selon d'autres variantes de réalisation ;

la figure 3A illustre un exemple d'évolution du contraste de démodulation en DC en fonction de la tension électrique appliquée entre les électrodes de modulation, dans les cas où le démodulateur comporte, ou non, les électrodes intermédiaires ;

la figure 3B illustre un exemple d'évolution du contraste de démodulation en AC en fonction de la fréquence de modulation, dans le cas où le démodulateur comporte les électrodes intermédiaires ;

la figure 3C illustre un exemple d'évolution du contraste de démodulation en AC en fonction de la fréquence de modulation, dans le cas où le démodulateur ne comporte pas les électrodes intermédiaires, et pour différentes valeurs de la profondeur des régions dopées de type p ;

les figures 4A à 4I illustrent différentes étapes d'un procédé de fabrication d'un démodulateur identique ou similaire à celui de la fig.1B.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

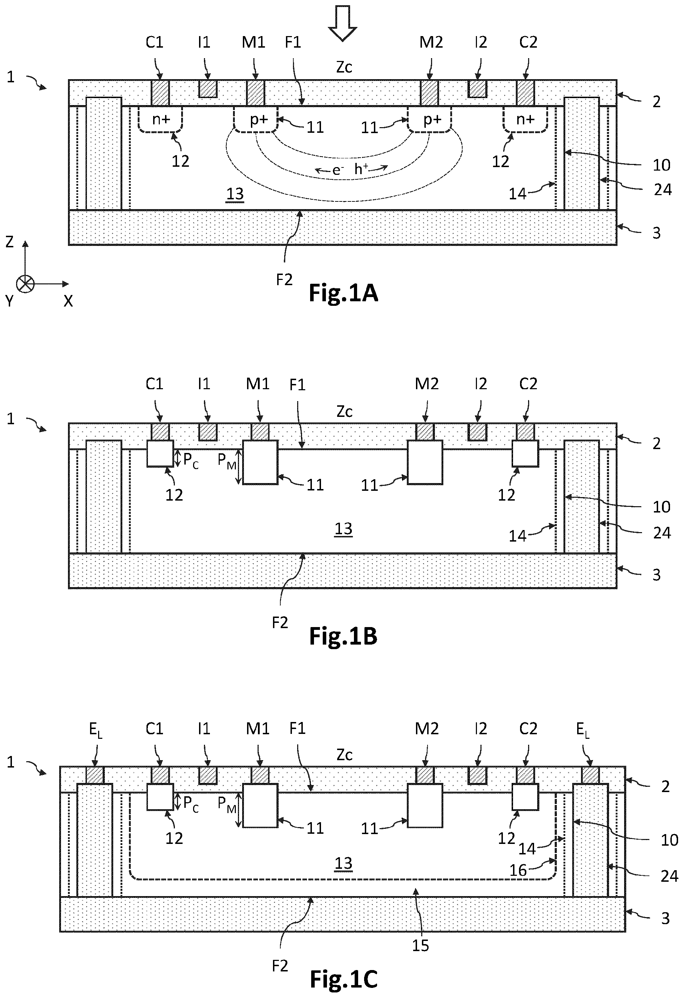

La figure 1A est une vue schématique et partielle, en coupe transversale, d'un démodulateur photonique 1 assisté par courant selon un mode de réalisation, appartenant ici à une matrice de démodulateurs 1 planaires identiques.

On définit ici et pour la suite de la description un repère direct tridimensionnel XYZ, où les axes X et Y forment un plan parallèle au plan principal des démodulateurs 1, et où l'axe Z est orienté suivant l'épaisseur de la portion de détection 10 du démodulateur 1, à partir de la deuxième face F2 en direction de la première face F1. Les termes « inférieur » et « supérieur » font référence à un positionnement croissant suivant la direction +Z définie sur la fig.1A.

Chaque démodulateur 1 comporte une portion de détection 10 réalisée ici à base de germanium, et est donc avantageusement adaptée à détecter un rayonnement lumineux dans le proche infrarouge (SWIR) correspondant à la gamme spectrale allant de $0.8\,\mu m$ à $1.7\,\mu m$ environ, voire à $2.5\,\mu m$ environ. Autrement dit, elle est adaptée à détecter un rayonnement lumineux de longueur d'onde allant de 800 nm jusqu'à une longueur d'onde de coupure supérieure à 1550nm.

Dans le cadre de l'invention, le démodulateur 1 comporte :

○ une portion de détection 10, s'étendant verticalement entre une première face F1 et une deuxième face F2. Elle comporte : au moins deux régions 11 dopées de type p, adaptées à générer et à moduler le courant de dérive, affleurant la première face F1 et situées de part et d'autre d'une zone centrale Zc de celle-ci ; et au moins deux régions 12 dopées de type n, adaptées à collecter les porteurs minoritaires photogénérés, affleurant la première face F1 et situées de manière adjacente aux régions 11 dopées de type p ;

○ une couche diélectrique de passivation 2, réalisée en au moins un matériau électriquement non conducteur, qui recouvre la première face F1 ;

○ des électrodes de modulation M1, M2, traversant la couche diélectrique de passivation 2 pour venir au contact des régions 11 dopées de type p ; et des électrodes de collection C1, C2, traversant la couche diélectrique de passivation 2 pour venir au contact des régions 12 dopées de type n ;

○ des électrodes intermédiaires I1, I2, polarisées en inverse (négativement), traversant en partie la couche diélectrique de passivation 2 et espacées de la première face F1 d'une distance non nulle, chacune étant située, en projection dans le plan principal XY, entre l'une des régions dopées 11 de type p et la région dopée 12 de type n adjacente.

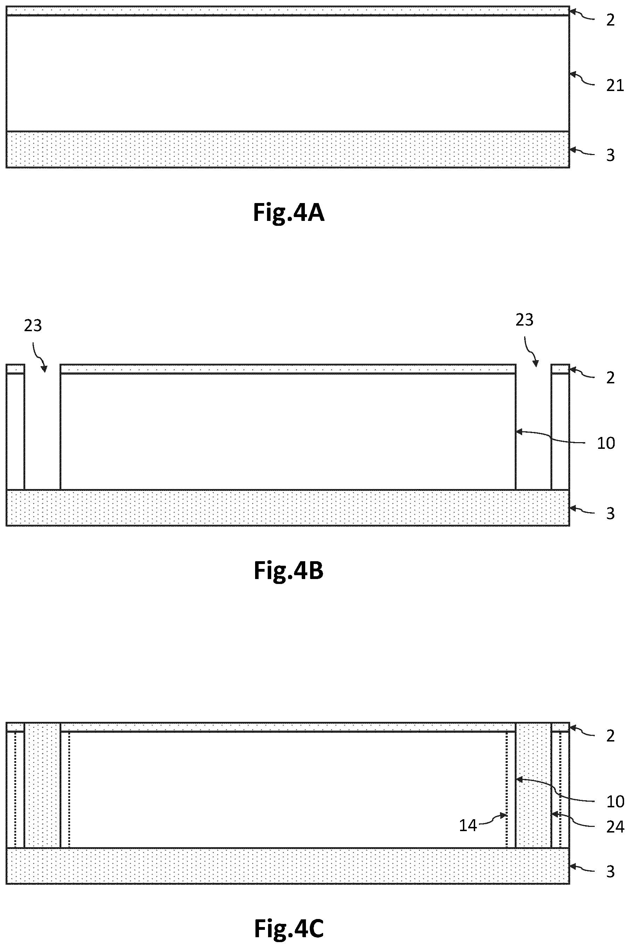

Dans cet exemple, les démodulateurs 1 présentent une configuration planaire dans la mesure où ils sont réalisés ici à partir d'une même couche semiconductrice principale 21 (cf. fig.4A). Cette dernière s'étend dans un plan principal XY, et présente une première face F1 et une deuxième face F2 opposées l'une à l'autre et parallèles au plan principal. Les deux faces F1, F2 s'étendent donc suivant des plans identiques pour chacun des démodulateurs 1, et délimitent verticalement (suivant l'axe d'épaisseur Z) les portions de détection 10 des démodulateurs 1. Aussi, les démodulateurs 1 ne présentent pas une structure en mesa dans la mesure où ils sont réalisés à partir de la même couche semiconductrice principale 21. La première face F1 est ici celle qui reçoit le rayonnement lumineux à détecter.

Chaque démodulateur 1 comporte une portion de détection 10 réalisée ici à base de germanium et donc adaptée à détecter le rayonnement lumineux dans le proche infrarouge (SWIR). La portion de détection 10 est une partie de la couche semiconductrice principale 21. L'épaisseur de la portion de détection 10, définie suivant l'axe Z entre les première et deuxième faces F1, F2, est ici sensiblement constante d'un démodulateur 1 à l'autre, par exemple est comprise entre quelques centaines de nanomètres et quelques microns, par exemple entre $1\,\mu m$ et $5\,\mu m$ environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre $1\,\mu m$ et $20\,\mu m$ environ, par

exemple égale à 10μm.

La portion de détection 10 est réalisée en au moins un matériau semiconducteur cristallin, et de préférence monocristallin. Elle est ici réalisée à base de germanium, c'est-à-dire que le ou les matériaux semiconducteurs sont du germanium ou un composé (binaire ou ternaire...) formé d'au moins le germanium. Ainsi, la portion de détection 10 peut être réalisée, par exemple, en germanium Ge, en silicium germanium SiGe, en germanium étain GeSn, voire en silicium germanium étain SiGeSn. Elle peut ainsi être réalisée en le même matériau semiconducteur et présenter des régions de différents types de conductivité (homojonction) de manière à former une jonction pn ou pin. Elle peut en variante être un empilement de sous-couches de différents matériaux semiconducteurs (hétérojonction), lesquels sont alors formés à base de germanium. De préférence, la portion de détection 10 est réalisée en germanium.

La portion de détection 10 comporte une région intermédiaire 13, non intentionnellement dopée (avec un éventuel dopage résiduel de type p) ou légèrement dopée p. La région intermédiaire 13 s'étend entre les faces F1 et F2, ainsi que dans le plan XY, et forme la région principale d'absorption du rayonnement lumineux à détecter. Elle entoure dans le plan XY les régions 11 dopées de type p et les régions 12 dopées de type n.

La portion de détection 10 comporte au moins deux régions 11 dopées de type p, ici dopées p+, adaptées à générer et à moduler le courant de dérive via le potentiel électrique qui leur est imposé par les électrodes de modulation M1 et M2. Elles sont ici dopées p+, et présentent par exemple un dopage compris entre $10^{18}$ et $10^{20}$ at/cm$^3$ environ, de préférence de $10^{19}$ at/cm$^3$. Elles affleurent la première face F1 et s'étendent en direction de la deuxième face F2 suivant l'axe Z sur une profondeur prédéfinie $P_M$. La profondeur $P_M$ peut être définie ici comme étant la distance suivant l'axe Z entre la première face F1 et une zone où le niveau de dopage est localement égal à la moitié du niveau de dopage maximal. Par ailleurs, les deux régions 11 dopées p+ sont situées dans le plan XY de part et d'autre d'une zone centrale Zc de la première face F1, où le rayonnement lumineux d'intérêt est destiné à être reçu.

La portion de détection 10 comporte également au moins deux régions 12 dopées de type n, ici dopées n+, adaptées à collecter les porteurs minoritaires photogénérés (photocourant) issus de l'absorption du rayonnement lumineux à détecter dans la région intermédiaire, via le potentiel électrique qui leur est imposé par les électrodes de collection C1 et C2. Elles sont ici dopées n+, et peuvent présenter un dopage pouvant être compris entre $5\times10^{18}$ et $10^{20}$ at/cm$^3$ environ. Elles affleurent la première face F1 et s'étendent en direction de la deuxième face F2 suivant l'axe Z sur une profondeur prédéfinie $P_C$. La profondeur $P_C$ peut être définie ici de la même manière que pour la profondeur $P_M$. Par ailleurs, les deux régions 12 dopées n+ sont situées de manière adjacente aux régions 11 dopées p+.

Notons que les régions 11 dopées de type p et les régions 12 dopées de type n peuvent être réalisées, comme sur la fig.1A, par implantation ionique localisée dans la portion de détection 10 à partir de la première face F1, ou en variante, comme illustré sur la fig.1B et la fig.1C, par dopage à la croissance lors d'une reprise d'épitaxie dans des échancrures formées à partir de la première face F1 de la portion de détection 10.

Par affleurer, on entend « arriver au niveau de », ou « s'étend à partir de ». Les régions 12 dopées n+ et les régions 11 dopées p+ sont disposées dans le plan XY de part et d'autre de la zone centrale Zc. Dans une configuration illustrée sur la fig.1A, les régions 11 dopées p+ sont disposées à proximité de la zone centrale Zc alors que les régions 12 dopées n+ en sont éloignées. En variante, cet agencement peut être inversé, de sorte que les régions 12 dopées n+ sont disposées à proximité de la zone centrale Zc alors que les régions 11 dopées p+ en sont éloignées.

La portion de détection 10 est avantageusement délimitée latéralement, dans le plan XY, par une portion latérale périphérique 24, remplie d'un matériau semiconducteur de préférence à base de silicium éventuellement dopé de type p. La portion latérale périphérique 24 assure une isolation optique latérale des démodulateurs 1 dans le plan XY, et assure avantageusement une mise en tension dans le plan XY du matériau de la portion de détection 10, augmentant ainsi la longueur d'onde de coupure d'absorption du rayonnement lumineux incident. Elle s'étend ici de préférence sur toute l'épaisseur de la portion de détection 10 pour déboucher sur la couche support 3. La face interne de cette portion latérale périphérique 24 définit alors la bordure latérale de la portion de détection 10.

Le matériau semiconducteur est de préférence réalisé à base de silicium, par exemple du silicium amorphe, du silicium mono ou polycristallin, du silicium germanium, de manière à former avantageusement une zone latérale 14 réalisée à base de silicium germanium. La zone latérale 14 affleure la bordure latérale et est au contact de la portion latérale périphérique 24. Ainsi, la zone latérale 14 présente une énergie de bande interdite (gap) supérieure à celle de la portion de détection 10 réalisée en germanium. Cette « ouverture de gap » latérale permet de diminuer la sensibilité du démodulateur 1 aux défauts présents à proximité des tranchées. On améliore ainsi également les performances du démodulateur 1.

Le démodulateur 1 comporte une couche diélectrique de passivation 2, réalisée en au moins un matériau électriquement non conducteur, comme un matériau isolant ou un matériau semiconducteur intrinsèque, qui recouvre la première face F1, et permet de passiver la portion de détection 10 et d'isoler électriquement les électrodes M1, M2, C1, C2, I1, I2. Elle est ainsi au contact des régions 11 dopées p+ et des régions 12 dopées n+, ainsi que de la région intermédiaire 13. Elle est de préférence réalisée en un oxyde, tel qu'un oxyde de silicium, d'aluminium, de germanium, d'hafnium, etc... ou par exemple en silicium intrinsèque. Elle présente une épaisseur par exemple comprise entre 2nm et 500nm.

Par ailleurs, la portion de détection 10 repose une couche support 3, réalisée ici en un matériau cristallin semiconducteur adapté à l'épitaxie du germanium de la portion de détection 10. Elle est ici réalisée en silicium. En variante, la portion de détection 10 peut reposer sur une couche isolante inférieure réalisée en un matériau électriquement isolant, éventuellement recouverte par une couche mince de nucléation à base de silicium. Cette couche support 3 peut être une couche supérieure d'un substrat SiGeOi ou d'un substrat GeOi.

Le démodulateur 1 comporte des électrodes de modulation M1, M2, permettant de générer et moduler le courant de dérive, qui traversent la couche diélectrique de passivation 2 pour venir au contact des régions 11 dopées p+ et leur appliquer un potentiel électrique positif ou nul. Elles sont connectées à un circuit électrique de commande. Il comporte également des électrodes de collection C1, C2, permettant de collecter les électrons photogénérés (photocourant), qui traversent la couche diélectrique de passivation 2 pour venir au contact des régions 12 dopées n+ et leur appliquer un potentiel électrique positif. Elles sont connectées à un circuit électrique de lecture.

Selon l'invention, le démodulateur 1 comporte également des électrodes intermédiaires I1, I2, polarisées en inverse (i.e. négativement), situées chacune entre l'une des régions 11 dopées de type p et la région adjacente 12 dopée de type n dans le plan XY. Autrement dit, en projection dans le plan XY, chaque électrode intermédiaire I1 et I2 est située entre une région dopée 11 et la région adjacente 12. Elles sont chacune espacées de la première face F1 par une distance non nulle par la couche diélectrique de passivation 2. Cette distance d'espacement, définie suivant l'axe Z, est de préférence comprise entre 5nm et 50nm, et de préférence égale à 10nm environ. Dans cet exemple, les électrodes intermédiaires I1, I2 sont situées chacune dans une échancrure non traversante de la couche diélectrique de passivation 2. Ces électrodes intermédiaires I1, I2 ne sont donc pas en contact avec la première face F1 de la portion de détection 10. Chaque électrode intermédiaire I1, I2 est destinée à être polarisée négativement, alors que les électrodes de modulation M1, M2 et de collection C1, C2 sont destinées à être polarisées de manière positive ou nul.

Les inventeurs ont constaté que la présence de ces électrodes intermédiaires I1, I2 entre les régions 11 dopées p+ et leurs régions 12 dopées n+ adjacentes, en projection dans le plan XY, permet d'améliorer l'isolation électrique entre les régions 11 dopées p+ et les régions 12 dopées n+, ce qui conduit à améliorer les performances du démodulateur 1. En effet, il apparaît qu'en l'absence de ces électrodes intermédiaires I1, I2, des électrons photogénérés peuvent être piégés par la recombinaison aux interfaces au niveau de la première face F1, dans les zones situées entre chaque région 11 dopée p+ et sa région 12 dopée n+ adjacente. Cela se traduit par une dégradation de la réponse impulsionnelle temporelle (TIR pour *Temporal Impulse Response* en anglais), de la sensibilité à la lumière parasite (PLS pour *Parasitic Light Sensitivity* en anglais), ainsi que de la bande passante du démodulateur. En revanche, la présence des électrodes intermédiaires I1, I2 conduit à une accumulation de porteurs majoritaires (trous) sous la couche diélectrique de passivation 2 au niveau de la première face F1, entre chaque région 11 dopée p+ et sa région 12 dopée n+ adjacente. Cela se traduit par une diminution des recombinaisons des électrons photogénérés à l'interface entre la couche diélectrique de passivation 2 et la portion de détection 10. Cette meilleure isolation électrique entre chaque région 11 dopée p+ et sa région 12 dopée n+ adjacente autorise une diminution de la distance dans le plan XY entre ces deux régions dopées. En termes de performances, la présence des électrodes intermédiaires I1, I2 se traduit par une augmentation de la réponse impulsionnelle temporelle, en particulier du contraste de démodulation en AC, de la bande passante, et donc par une réduction de la sensibilité à la lumière parasite.

La figure 1B est une vue schématique et partielle, en coupe transversale, d'un démodulateur photonique 1 assisté par courant selon un autre mode de réalisation. Ici, le démodulateur 1 se distingue de celui de la fig.1A essentiellement en ce que les régions 11 dopées p+ de modulation présentent une profondeur $P_M$ plus importante que la profondeur $P_C$ des régions 12 dopées n+ de collection. De préférence, les régions 11 dopées p+ sont du côté de la zone centrale Zc de la première face F1 alors que les régions 12 dopées n+ en sont éloignées.

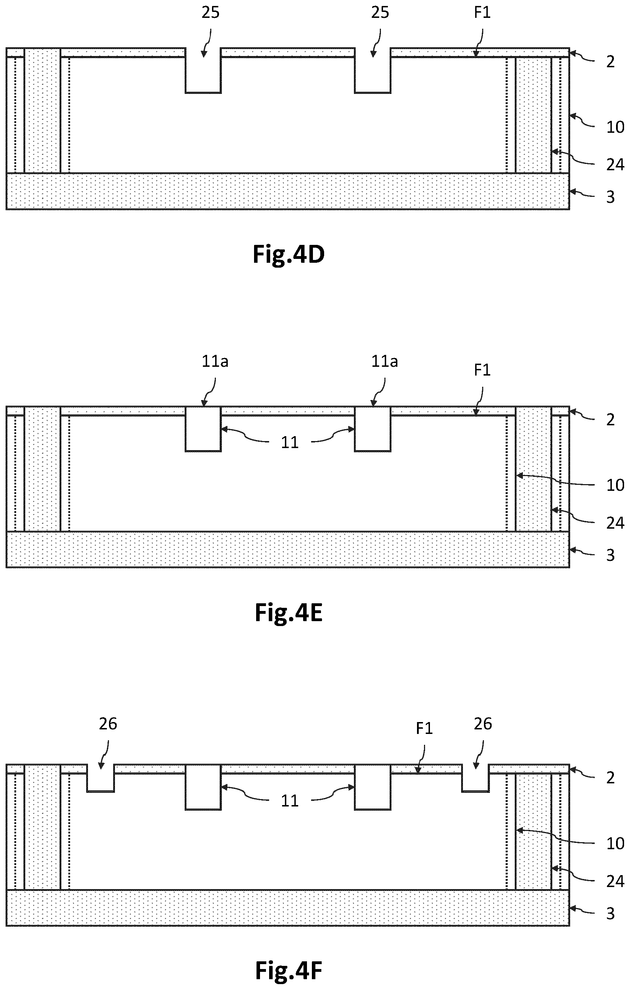

Dans cet exemple, chaque région 11 dopée p+ est formée par une portion semiconductrice 11a, ici dopée p+, réalisée à base de germanium et de préférence en le même matériau que celui de la portion de détection 10, par reprise d'épitaxie à partir d'une échancrure 25 pratiquée à partir de la première face F1 (cf. fig.4D et fig.4E). La portion semiconductrice 11a est dopée de type p à la croissance et non pas par implantation ionique localisée. De préférence, les portions semiconductrices 11a sont réalisées en germanium dopé en bore avec un niveau de dopage de l'ordre de $10^{19}$ cm$^{-3}$.

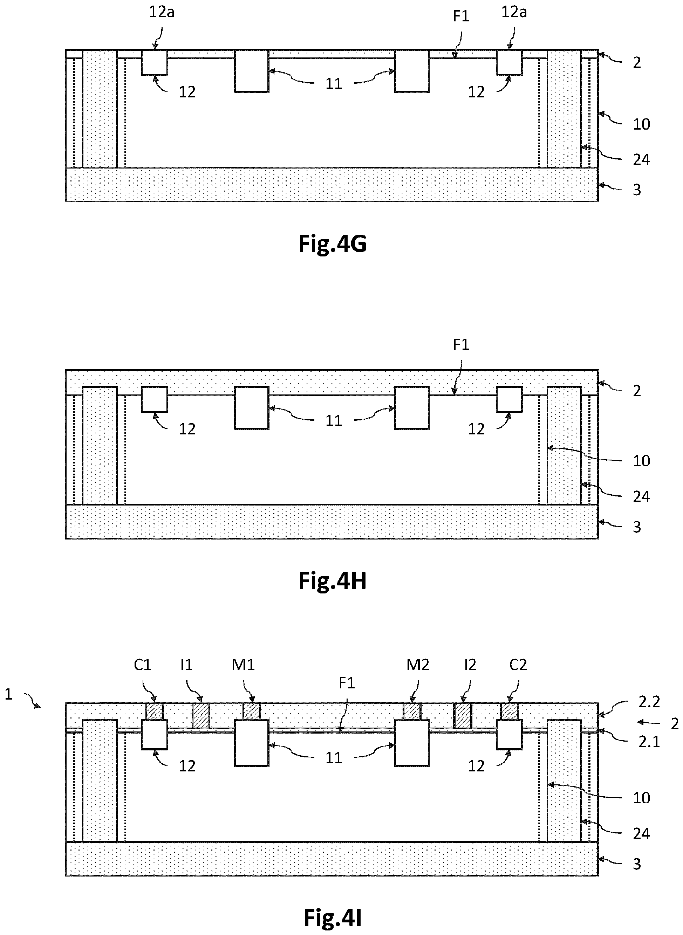

De préférence, les régions 12 dopées n+ sont également formées chacune par une portion semiconductrice 12a, ici dopée n+, réalisée à base de germanium et de préférence en le même matériau que celui de la portion de détection 10, par reprise d'épitaxie à partir d'une échancrure 26 pratiquée à partir de la première face F1 (cf. fig.4F et fig.4G). La portion semiconductrice 12a est dopée à la croissance et non pas par implantation ionique localisée.

La profondeur $P_M$ des échancrures 25 des régions 11 dopées p+ (et donc la profondeur de ces régions 11 dopées p+), est supérieure à la profondeur $P_C$ des échancrures 26 des régions 12 dopées n+ (et donc à celle des régions 12 dopées n+). Les inventeurs ont constaté que cette configuration se traduit par une amélioration de la réponse impulsionnelle temporelle, en particulier le contraste de démodulation en AC, et donc par une réduction de la sensibilité à la lumière parasite.

La profondeur $P_M$ est de préférence comprise entre 0.4 et 1.2μm, par exemple égale à 1μm environ. Cette profondeur $P_M$ est obtenue ici par la reprise d'épitaxie dans l'échancrure 25 et un dopage à la croissance, et, de préférence, par la reprise d'épitaxie dans l'échancrure 26 et le dopage à la croissance, ce qui permet de limiter voire d'écarter les risques de court-circuit (entre chaque région 11 dopée p+ et sa région 12 dopée n+ adjacente) qui seraient présents dans le cas d'une implantation ionique.

La figure 1C est une vue schématique et partielle, en coupe transversale, d'un démodulateur photonique 1 assisté par courant selon un autre mode de réalisation. Ici, le démodulateur 1 se distingue de celui de la fig.1B essentiellement en ce que la portion de détection 10 comporte une région inférieure 15 dopée de type p, qui affleure la deuxième face F2, et s'étend dans le plan XY jusqu'à la portion latérale périphérique 24. Celle-ci est alors dopée de type p, et au moins une électrode $E_L$ est au contact de la portion latérale périphérique 24 pour assurer la polarisation de la région inférieure 15. Un potentiel électrique négatif peut être appliqué par l'électrode $E_L$. La région inférieure 15 permet de réduire les recombinaisons des électrons photogénérés au niveau des éventuels défauts du germanium présents au niveau de la deuxième face F2. Ainsi, on améliore ainsi les performances du démodulateur 1.

Une région latérale 16 dopée de type p peut être présente dans la portion de détection 10, le long de la portion latérale périphérique 24. Cette région latérale 16 dopée p+ permet d'éviter que la zone de charge d'espace du démodulateur 1 ne s'étende jusqu'à la bordure latérale. Ainsi, on limite la contribution de cette zone (potentiellement non exempte de défauts liés à la réalisation des tranchées) au courant d'obscurité.

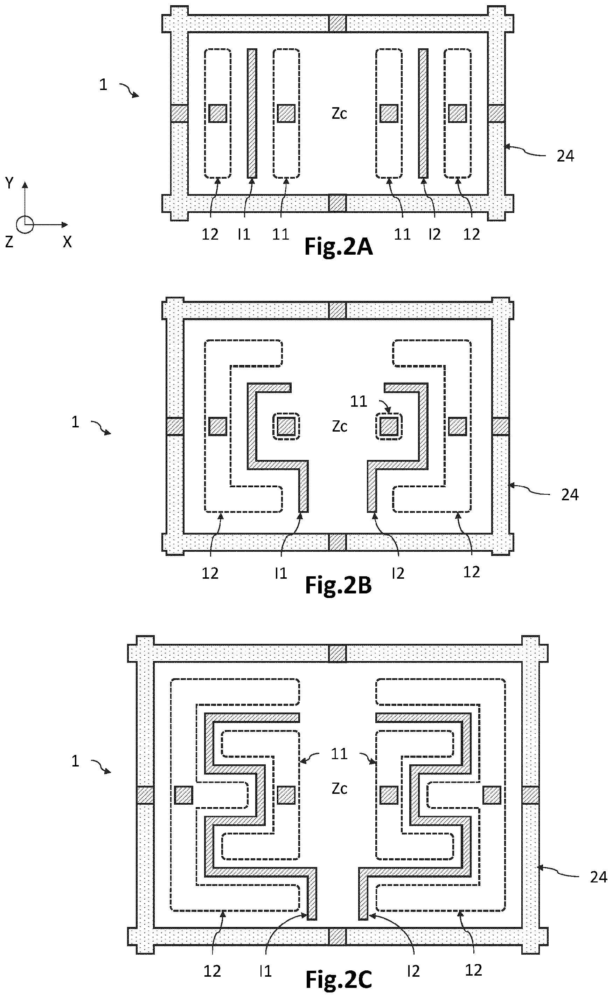

Les figures 2A à 2C sont des vues de dessus, schématiques et partielles, d'une matrice de démodulateurs 1 selon différentes variantes. Dans ces exemples, les régions 11 dopées p+ sont situés du côté de la zone centrale Zc de la première face F1 alors que les régions 12 dopées n+ adjacentes en sont éloignées. Cependant, la configuration inverse est possible. Par ailleurs, la portion de détection 10 est délimitée ici par la portion latérale périphérique 24, laquelle assure l'isolation optique des démodulateurs 1 dans le plan XY ainsi que la mise en tension de la portion de détection 10.

Sur la fig.2A, les régions 11 dopées p+, les régions 12 dopées n+, et les électrodes intermédiaires I1, I2 s'étendent dans le plan XY de manière rectiligne, ici suivant l'axe Y, et parallèles les unes aux autres.

Sur la fig.2B, les régions 11 dopées p+ présentent une forme dans le plan XY sensiblement carrée, mais elles pourraient s'étendre également de manière rectiligne suivant l'axe Y. Les régions 12 dopées n+ s'étendent dans le plan XY de manière à entourer partiellement les régions 11 dopées p+ : elles présentent chacune une partie principale qui s'étend suivant l'axe Y et deux parties latérales qui s'étendent à partir des extrémités de la partie principale suivant la direction +X. Chaque électrode intermédiaire I1, I2 s'étend dans le plan XY de manière complémentaire à la région 12 dopée n+ de manière à rester située entre la région 11 dopée p+ et la région 12 dopée n+ adjacente.

Sur la fig.2C, les régions 11 dopées p+ et les régions 12 dopées n+ présentent une configuration interdigitée. Chaque région 12 dopée n+ présente une forme en E avec une partie principale orientée suivant l'axe Y, et avec deux parties latérales d'extrémité et une partie centrale orientées suivant l'axe X. La région 11 dopée p+ adjacente présente une forme en C où les parties latérales d'extrémité s'étendent entre les parties latérales et centrale de la région 12 dopée n+. Chaque électrode intermédiaire I1, I2 s'étend entre la région 11 dopée p+ et la région 12 dopée n+ adjacente de manière à rester située entre celles-ci.

Ces figures illustrent différentes configurations de l'agencement relatif des régions 11 dopées p+, des régions 12 dopées n+, et des électrodes intermédiaires I1, I2, mais d'autres configurations sont bien entendu possibles.

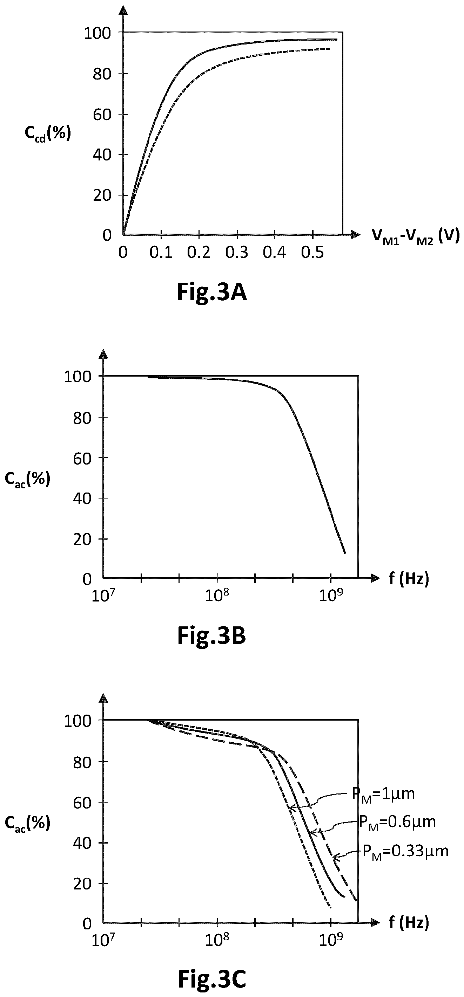

Les figures 3A à 3C illustrent des exemples de figures de mérite d'un démodulateur 1 comportant l'une ou l'autre des caractéristiques avantageuses décrites précédemment.

La figure 3A est un exemple d'évolution du contraste de démodulation $C_{dc}$ lorsqu'on considère la composante continue dc du photocourant mesuré, en fonction de la tension électrique appliquée entre les électrodes de modulation M1 et M2.

Comme décrit notamment dans l'article scientifique de Dalla Betta et al. intitulé Design and Characterization of Current-Assisted Photonic Demodulators in 0.18-μm CMOS Technology, IEEE Trans. Electron Devices, vol. 58, no. 6, pp.1702-1707, June 2011, le contraste de démodulation $C_d$ est défini tel que : $C_d = f_{C1}^{ac} \times I_{tot}^{ac}/I_{tot}^{dc}$ , où $I_{tot}$ est le photocourant total collecté aux électrodes C1 et C2 : $I_{tot} = I_{C1} + I_{C2}$ ; et $f_{C1}$ est la fraction du photocourant $I_{tot}$ collecté par l'électrode C1. Dans le cas où le rayonnement lumineux incident est modulé de manière sinusoïdale en puissance et que la tension électrique appliquée entre les électrodes de modulation M1 et M2 est également sinusoïdale, en phase et de même fréquence que le rayonnement lumineux, les photocourants collectés peuvent s'écrire ainsi :

$$I_{C1} = \left[ \frac{1}{2} + f_{C1}^{ac} \sin(2\pi f t) \right] \times \left[ I_{tot}^{dc} + I_{tot}^{ac} \sin(2\pi f t - \varphi) \right]$$

$$I_{C2} = \left[ \frac{1}{2} - f_{C1}^{ac} \sin(2\pi f t) \right] \times \left[ I_{tot}^{dc} + I_{tot}^{ac} \sin(2\pi f t - \varphi) \right]$$

où $I_{tot}^{dc}$ et $I_{tot}^{ac}$ sont les composantes continue et alternative du photocourant mesuré $I_{tot}$, $f_{C1}^{ac}$ est l'amplitude de la composante AC de la fraction $f_{C1}$, f est la fréquence de modulation, et ϕ est le déphasage entre la lumière émise et la lumière reçue. A partir de ces deux équations, on peut accéder à la moyenne des courants $I_{C1}$ et $I_{C2}$ qui contiennent directement la phase $\varphi$, qui peuvent s'écrire comme :

$$< I_{C1} > = \frac{1}{2} I_{tot}^{dc} + \frac{1}{2} f_{C1}^{ac} I_{tot}^{ac} \cos(\varphi)$$

$$< I_{C2} > = \frac{1}{2} I_{tot}^{dc} - \frac{1}{2} f_{C1}^{ac} I_{tot}^{ac} \cos(\varphi)$$

On peut donc définir le contraste de démodulation en DC tel que : $C_{dc} = (I_{C1} - I_{C2}) / I_{tot}$, et obtenir la distance « d » de la cible peut être extraite en utilisant la phase à partir de la formule suivante :

$$d = \frac{c\varphi}{4\pi f}$$

où « c » est la vitesse de la lumière dans le vide.

Dans cet exemple, le rayonnement lumineux détecté est dans le proche infrarouge et présente une longueur d'onde centrale de 1.4$\mu$m et une irradiance de 0.001 W/cm². La portion de détection 10 est réalisée en germanium. Les régions 11 dopées p+ présentent une profondeur $P_M$ égale à 1.1$\mu$m et les régions 12 dopées n+ présentent une profondeur $P_C$ égale à 0.23$\mu$m. Elles sont espacées dans le plan XY d'une distance de 0.5$\mu$m.

Comme le montre la fig.3A, le contraste de démodulation $C_{dc}$ en DC augmente de 0 à plus de 90% en fonction de la tension de modulation $V_{M1}$-$V_{M2}$. Dans le cas où le démodulateur 1 ne comporte pas d'électrodes intermédiaires I1, I2 (trait pointillé sur la fig.3A), le contraste de démodulation $C_{dc}$ présente une valeur de 80% environ à 0.2V, et une valeur de 92% environ à 0.5V. En revanche, dans le cas où le démodulateur 1 comporte des électrodes intermédiaires I1, I2 telles que décrites précédemment (trait continu sur la fig.3A), le contraste de démodulation $C_{dc}$ présente une valeur de 90% environ à 0.2V, et une valeur de 97% environ à 0.5V. Aussi, la présence des électrodes intermédiaires I1, I2 améliore grandement les performances du démodulateur 1.

La fig.3B illustre l'évolution du contraste de démodulation $C_{ac}$ en AC dans le cas du démodulateur 1 de la fig.3A qui comporte les électrodes intermédiaires I1, I2. Cette évolution est ici fonction de la fréquence de modulation f. Le contraste de démodulation $C_{ac}$ est défini par la relation suivante (simplifiée ici à une configuration bidimensionnelle) : $C_{ac}$ (f) = ( $Q_{C1}(t)$-$Q_{C2}(t)$ )/$Q_{tot}$, où $Q_{C1}$ et $Q_{C2}$ sont les charges électriques au niveau des électrodes C1 et C2, et $Q_{tot}$ est la charge totale dans le démodulateur 1. Rappelons ici que le contraste de démodulation $C_{dc}$ en DC ne fait pas intervenir la fréquence (contraste en statique). En revanche, le contraste de démodulation $C_{ac}$ en AC est un contraste qui est extrait à partir de la variation temporelle des courants récoltés par les régions dopées n+ de collection. L'intégration de ces deux courants donne les quantités de charges dans le démodulateur.

Il apparaît que le contraste de démodulation $C_{ac}$ est égal à 98.4% à 100MHz, à 98.0% à 200MHz, et à 95.7% à 300MHz. La sensibilité à la lumière parasite PLS, définie par la relation suivante : PLS = ( 1-$C_{ac}$(f=0) )/2, est de l'ordre de 1% seulement. Comme nous allons le voir avec la fig.3C, les performances du démodulateur 1 sont grandement améliorées également en termes de contraste de démodulation $C_{ac}$ et de PLS.

La fig.3C illustre l'évolution du contraste de démodulation $C_{ac}$, en fonction de la fréquence de modulation f, d'un démodulateur 1 ne comportant pas les électrodes intermédiaires I1, I2, et pour différentes valeurs de la profondeur $P_M$ des régions 11 dopées p+. Alors que la profondeur $P_C$ des régions 12 dopées n+ reste fixée à 0.23$\mu$m, la profondeur $P_M$ est de 0.33$\mu$m, 0.6$\mu$m ou de 1$\mu$m. La lumière incidente est une impulsion d'une durée de 50ps à une longueur d'onde centrale de 1.4$\mu$m avec une irradiance de 0.1 W/cm². Les potentiels électriques $V_{C1}$ et $V_{C2}$ sont égaux à +1V et la tension électrique $V_{M1}$-$V_{M2}$ entre les électrodes M1 et M2 est égale à +0.7V.

Il apparaît que le contraste de démodulation $C_{ac}$ augmente avec la profondeur $P_M$ des régions 11 dopées p+. Pour la profondeur $P_M$ de 0.33$\mu$m, 0.6$\mu$m puis 1$\mu$m, le contraste de démodulation $C_{ac}$ passe, respectivement, de 90.3%, à 92.8% puis à 94.9%, pour la fréquence de 100MHz. De plus, il passe de 87.2%, à 89.9%, puis à 90.7%, pour la fréquence de 200MHz, et enfin il passe de 84.2%, à 85.4%, puis à 77.9%, pour la fréquence de 300MHz. Enfin, la PLS diminue de 3.7% à 2.8%, puis à 1.8%. Aussi, le fait d'augmenter la profondeur $P_M$ des régions 11 dopées p+ permet effectivement d'améliorer les performances du démodulateur 1. Notons également que la présence des électrodes intermédiaires I1, I2 permet également d'améliorer les performances du démodulateur 1, dans la mesure où le contraste de démodulation $C_{ac}$ passe notamment de 90.7% à 98% pour la fréquence de 200MHz, la PLS diminue de 1.8% à 1% environ, et enfin la bande passante est augmentée.

Aussi, la présence des électrodes intermédiaires I1 et I2 permet d'améliorer grandement les performances du démodulateur 1, en termes à la fois de contraste de démodulation $C_{ac}$ et de PLS mais également de bande passante. De plus, le fait de réaliser des régions 11 dopées p+ plus profondes que les régions 12 dopées n+ permet également d'améliorer les performances du démodulateur 1.

Les figures 4A à 4I illustrent différentes étapes d'un procédé de fabrication d'une matrice de démodulateurs photoniques 1 assistés par courant identiques ou similaires à celui illustré sur la fig.1B. Les démodulateurs 1 présentent ici une configuration planaire. Ils sont réalisés à base de germanium, et sont donc adaptés à détecter un rayonnement infrarouge dans le proche infrarouge. Les portions de détection 10 sont réalisées en germanium.

En référence à la fig.4A, on réalise la couche semiconducteur principale 21 par épitaxie à partir de la couche support 3. Dans cet exemple, la couche support 3 est en silicium monocristallin, et la couche semiconductrice principale 21 est en germanium non intentionnellement dopé et présente une épaisseur comprise entre $1\mu$m et $3\mu$m environ, par exemple $1.5\mu$m. Elle peut être réalisée comme décrit notamment dans la publication de Hartmann & Aubin intitulé Assessment of the growth/etch back technique for the production of Ge strain-relaxed buffers on Si, Journal of Crystal Growth, 488 (2018), 43. La couche semiconductrice principale 21 présente alors une très faible densité de dislocations émergentes (par exemple de l'ordre de $10^7$ dislocations/cm$^2$), ce qui contribue à réduire le courant d'obscurité dans la portion de détection 10 du démodulateur 1. Comme indiqué précédemment, la couche semiconductrice principale 21 peut comporter une région inférieure dopée de type p, par exemple d'une épaisseur de 200nm et dont le niveau de dopage en bore est de l'ordre de $5\times10^{19}$ cm$^{-3}$.

En variante, la couche semiconductrice principale 21 peut être déposée à partir d'un substrat de type GeOI (pour *Germanium On Insulator,* en anglais). Ainsi, la couche support 3 peut être une couche de nucléation en germanium de quelques dizaines à quelques centaines de nanomètres reposant sur une couche inférieure de 2 nm environ de silicium, laquelle repose sur une couche isolante de quelques dizaines de nm à quelques microns d'épaisseur, puis sur un substrat silicium. Un tel substrat GeOI peut être réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015).

Enfin, on dépose une couche diélectrique de passivation 2 sur la face supérieure de la couche semiconductrice principale 21. Cette couche diélectrique de passivation 2 peut être formée d'une première sous-couche 2.1 de passivation (cf. fig.4I), réalisée par exemple en un oxyde d'aluminium déposé par un dépôt en couche atomique (ALD pour *Atomic Layer Deposition* en anglais) d'une épaisseur de l'ordre de 5 à 30nm, par exemple 10nm, ou même par une fine couche de silicium non dopé avec une épaisseur allant de 1 à 4 nm, déposée par épitaxie sur le germanium de la portion de détection 10. Ensuite, une deuxième sous-couche 2.2 (cf. fig.4I), réalisée par exemple en un oxyde de silicium tel que du SiO$_2$ TEOS (orthosilicate de tétraéthyle) d'une épaisseur de l'ordre de 20 à 100nm, est déposée sur la première sous-couche 2.1.

En référence à la fig.4B, on réalise, par photolithographie et gravure, des tranchées 23 destinées à pixelliser les démodulateurs 1 par les portions latérales périphériques 24. On réalise ainsi une gravure localisée de la couche semiconductrice principale 21 en germanium pour déboucher sur la couche support 3. Chaque tranchée 23 s'étend de préférence continûment dans le plan XY autour d'un démodulateur 1. On obtient ainsi une pluralité de portions de détection 10 séparées les unes des autres par une tranchée continue 23. Elles sont obtenues de préférence par une technique de gravure anisotrope, de manière à obtenir une bordure latérale sensiblement verticale suivant l'axe Z. Les tranchées 23 présentent une dimension transversale (largeur) dans le plan XY pouvant être comprise entre $0.5\mu$m et $2\mu$m, par exemple égale à $1\mu$m. Les portions de détection 10 peuvent ainsi présenter une forme dans le plan XY par exemple circulaire, ovale, polygonale, par exemple carrée, ou toute autre forme.

En référence à la fig.4C, on réalise la portion latérale périphérique 24, par épitaxie dans les tranchées 23 d'un matériau semiconducteur cristallin à base de silicium. Il peut notamment s'agir de silicium ou de polysilicium. Il peut être dopé de type p, par exemple au bore avec un niveau de dopage de l'ordre de $4\times10^{19}$ cm$^{-3}$. Ce matériau présente un coefficient de dilatation thermique inférieur à celui de la portion de détection 10 à base de germanium, de sorte qu'au retour à la température ambiante (après l'épitaxie du silicium dans les tranchées), la portion de détection 10 présente des contraintes mécaniques en tension dans le plan XY. Ensuite, un recuit d'interdiffusion est effectué pour former la zone latérale 14 à base de SiGe. Enfin, une étape de polissage mécanochimique (CMP) est ensuite effectuée, avec arrêt sur la face supérieure de la couche diélectrique de passivation 2, pour éliminer le matériau à base de silicium en excès et planariser la face supérieure de l'empilement.

En référence à la fig.4D, on réalise, par photolithographie et gravure, des échancrures 25 (ouvertures non traversantes) au travers de la couche diélectrique de passivation 2 et au sein de la portion de détection 10, au niveau de la première face F1, de part et d'autre de la zone centrale Zc. Ces échancrures 25 sont destinées à la réalisation des régions 11 dopées p+. La profondeur des échancrures 25 par rapport à la première face F1 correspond à la profondeur $P_M$ de ce que seront les régions 11 dopées p+. Pour une portion de détection 10 d'une épaisseur de $1.5\mu$m environ, la profondeur $P_M$ peut être de l'ordre de 0.4 à $1\mu$m environ.

En référence à la fig.4E, on réalise les régions 11 dopées p+, par reprise d'épitaxie ici de germanium dans les échancrures 25, avec dopage de type p (ici au bore) à la croissance. La température de croissance peut être de l'ordre de 600°C. Le niveau de dopage peut être de l'ordre de $10^{19}$ cm$^{-3}$. Les régions 11 dopées p+ sont formées par les portions semiconductrices 11a. Une étape de polissage mécanochimique est ensuite effectuée, avec arrêt sur la face supérieure de la couche diélectrique de passivation 2.

En référence à la fig.4F, on réalise, par photolithographie et gravure, des échancrures 26 au travers de la couche diélectrique de passivation 2 et au sein de la portion de détection 10, à partir de la première face F1. Ces échancrures 26 sont destinées à la réalisation des régions 12 dopées n+. Elles sont situées également de part et d'autre de la zone centrale Zc de la première face F1, et sont adjacentes des premières régions 11 dopées p+. La profondeur des échancrures 26 par rapport à la première face F1 correspond à la profondeur $P_C$ de ce que seront les régions 12 dopées n+, cette profondeur $P_C$ étant avantageusement inférieure à $P_M$.

En référence à la fig.4G, on réalise les régions 12 dopées n+, par reprise d'épitaxie ici de germanium dans les échancrures 26, avec dopage de type n (ici au phosphore) à la croissance. La température de croissance peut être de l'ordre de 400 à 600°C. Le niveau de dopage peut être de l'ordre de $5\times10^{18}$ à $10^{20}$ cm$^{-3}$. Les régions 12 dopées n+ sont formées par les portions semiconductrices 12a. Une étape de polissage mécanochimique est ensuite effectuée, avec arrêt sur la face supérieure de la couche diélectrique de passivation 2. Rappelons que, en variante, les régions 12 dopées n+ peuvent être réalisées par implantation ionique localisée de phosphore, arsénique ou antimoine.

En référence à la fig.4H, on dépose une nouvelle couche diélectrique sur la couche diélectrique 2 sous-jacente, de manière à recouvrir les régions 11 dopées p+, les régions 12 dopées n+ et la portion latérale périphérique 24.

En référence à la fig.4I, on réalise les électrodes de modulation M1 et M2 qui s'étendent au travers de la couche diélectrique de passivation 2 et viennent au contact des régions 11 dopées p+ ; les électrodes de collection C1 et C2 qui s'étendent au travers de la couche diélectrique de passivation et viennent au contact des régions 12 dopées n+ ; et les électrodes intermédiaires I1, I2. Ces dernières sont situées, en projection dans le plan XY, entre chaque région dopée p+ et sa région dopée n+ adjacente. Elles sont espacées de la première face F1 d'une distance non nulle par la couche diélectrique de passivation 2. Dans le cas où celle-ci est formée d'une première sous-couche 2.1 en $Al_2O_3$ recouverte d'une deuxième sous-couche 2.2 en TEOS, les électrodes intermédiaires I1, I2 peuvent s'étendre au travers de la sous-couche 2.2 en TEOS et viennent au contact de la sous-couche 2.1 en $Al_2O_3$.

On obtient ainsi une matrice de démodulateurs photoniques 1 assistés par courant, ici en configuration planaire, qui présente des performances améliorées, notamment en termes de contraste de démodulation $C_{ac}$, de PLS, et de bande passante. On écarte également les risques de court-circuit entre les régions 11 dopées p+ et les régions 12 dopées n+ par le fait de réaliser les régions profondes 11 dopées p+ par reprise d'épitaxie et dopage à la croissance, et de préférence en faisant de même pour la réalisation des régions peu profondes 12 dopées n+.

Des modes de réalisation particuliers viennent d'être décrits. Différentes variantes et modifications apparaîtront à l'homme du métier.


**Revendications**

**1.** Démodulateur photonique (1) assisté par courant, adapté à détecter un rayonnement lumineux d'intérêt, comportant :

○ une portion de détection (10), s'étendant verticalement entre une première face (F1) et une deuxième face (F2) parallèles à un plan principal, et comportant :

• au moins deux régions (11) dopées de type p, destinées à générer et à moduler un courant de dérive dans la portion de détection (10), affleurant la première face (F1) et situées de part et d'autre d'une zone centrale (Zc) de la première face (F1) ;
• au moins deux régions (12) dopées de type n, adaptées à collecter les porteurs de charge minoritaires photogénérés lors de l'absorption du rayonnement lumineux d'intérêt dans la portion de détection (10), affleurant la première face (F1) et situées de manière adjacente aux régions dopées (11) de type p ;

○ une couche diélectrique de passivation (2), réalisée en un matériau électriquement isolant, et recouvrant la première face (F1) ;
○ des électrodes de modulation (M1, M2), traversant la couche diélectrique de passivation (2) et au contact des régions dopées (11) de type p; et des électrodes de collection (C1, C2), traversant la couche diélectrique de passivation (2) et au contact des régions dopées (12) de type n ;
○ **caractérisé en ce qu'**il comporte des électrodes intermédiaires (I1, I2), destinées à être polarisées négativement, traversant en partie la couche diélectrique de passivation (2) et espacées de la première face (F1) d'une distance non nulle, chacune étant située, en projection dans le plan principal, entre l'une des régions dopées (11) de type p et la région dopée (12) de type n adjacente.

**2.** Démodulateur photonique (1) selon la revendication 1, dans lequel les électrodes intermédiaires (I1, I2) sont espacées de la première face (F1) d'une distance comprise entre 5nm et 50nm.

3. Démodulateur photonique (1) selon la revendication 1 ou 2, dans lequel les régions (11) dopées de type p présentent une profondeur ($P_M$) à partir de la première face (F1) supérieure à une profondeur ($P_C$) des régions (12) dopées de type n.

4. Démodulateur photonique (1) selon l'une quelconque des revendications 1 à 3, dans lequel les régions (11) dopées de type p sont situées, en projection dans le plan principal, à proximité de la zone centrale (Zc), et les régions (12) dopées de type n en étant éloignées.

5. Démodulateur photonique (1) selon l'une quelconque des revendications 1 à 4, dans lequel les régions (11) dopées de type p sont des premières portions semiconductrices (11a) situées dans des premières échancrures (25) de la portion de détection (10).

6. Démodulateur photonique (1) selon l'une quelconque des revendications 1 à 5, dans lequel les régions (12) dopées de type n sont des premières portions semiconductrices (12a) situées dans des deuxièmes échancrures (26) de la portion de détection (10).

7. Démodulateur photonique (1) selon l'une quelconque des revendications 1 à 6, dans lequel la portion de détection (10) est réalisée à base de germanium.

8. Démodulateur photonique (1) selon l'une quelconque des revendications 1 à 7, comportant une portion latérale périphérique (24) entourant la portion de détection (10) dans le plan principal, réalisée en un matériau semiconducteur à base de silicium.

9. Démodulateur photonique (1) selon les revendications 7 et 8, dans lequel la portion de détection (10) comporte une zone latérale (14) réalisée à base de SiGe, située à l'interface avec la portion latérale périphérique (24).

10. Procédé de fabrication d'un démodulateur photonique (1) selon l'une quelconque des revendications précédentes, comportant les étapes suivantes :

   ◦ réalisation de la portion de détection (10) en un matériau non intentionnellement dopé ;
   ◦ réalisation des régions (11) dopées de type p et des régions (12) dopées de type n dans la portion de détection (10) ;
   ◦ dépôt d'une couche diélectrique de passivation sur la portion de détection (10) ;
   ◦ réalisation des électrodes de modulation, des électrodes de collection, et des électrodes intermédiaires.

11. Procédé de fabrication selon la revendication 10, dans lequel les régions (11) dopées de type p présentent une profondeur ($P_M$) à partir de la première face (F1) supérieure à la profondeur ($P_C$) des régions (12) dopées de type n.

12. Procédé de fabrication selon la revendication 10 ou 11, dans lequel la réalisation des régions (11) dopées de type p comporte les étapes suivantes :

   ◦ réalisation de premières échancrures (25) dans la portion de détection (10) à partir de la première face (F1) ;
   ◦ réalisation par épitaxie, dans les premières échancrures (25), de premières portions semiconductrices (11a) dopées de type p à la croissance.

13. Procédé de fabrication selon l'une quelconque des revendications 10 à 12, dans lequel la réalisation des régions (11) dopées de type n comporte les étapes suivantes :

   ◦ réalisation de deuxièmes échancrures (26) dans la portion de détection (10) à partir de la première face (F1) ;
   ◦ réalisation par épitaxie, dans les deuxièmes échancrures (26), de deuxièmes portions semiconductrices (12a) dopées de type n à la croissance.

14. Procédé de fabrication selon les revendications 12 et 13, dans lequel les premières échancrures (25) présentent une profondeur ($P_M$) supérieure à la profondeur ($P_C$) des deuxièmes échancrures (26).

**Patentansprüche**

1. Stromunterstützter photonischer Demodulator (1), geeignet zur Erkennung einer relevanten Lichtstrahlung, umfassend:

   ◦ einen Erfassungsabschnitt (10), der sich vertikal zwischen einer ersten Fläche (F1) und einer zweiten Fläche (F2) erstreckt, die parallel zu einer Hauptebene sind, und umfassend:

   • mindestens zwei p-typdotierte Bereiche (11), die dazu bestimmt sind, einen Driftstrom in dem Erfassungsabschnitt (10) zu erzeugen und zu modulieren, der mit der ersten Fläche (F1) bündig ist und sich auf beiden Seiten eines zentralen Bereichs (Zc) der ersten Fläche (F1) befindet;
   • mindestens zwei n-typdotierte Bereiche (12), die geeignet sind, die bei der Absorption der relevanten Lichtstrahlung in dem Erfassungsabschnitt (10) photogenerierten Minderheitsladungsträger zu sammeln, die mit der ersten Fläche (F1) bündig sind und sich angrenzend zu den p-typdotierten Bereichen (11) befinden;

   ◦ eine dielektrische Passivierungsschicht (2), die aus einem elektrisch isolierenden Material hergestellt ist und die erste Seite (F1) bedeckt;
   ◦ Modulationselektroden (M1, M2), die die dielektrische Passivierungsschicht (2) durchdringen und die p-typdotierten Bereiche (11) berühren; und Sammelelektroden (C1, C2), die die dielektrische Passivierungsschicht (2) durchdringen und die n-typdotierten Bereiche (12) berühren;
   ◦ **dadurch gekennzeichnet, dass** es Zwischenelektroden (I1, I2) aufweist, die dazu bestimmt sind, negativ polarisiert zu werden, die die dielektrische Passivierungsschicht (2) teilweise durchqueren und von der ersten Seite (F1) in einem Abstand von nicht null beabstandet sind, wobei sich jede in der Hauptebene in Projektion zwischen einem der p-typdotierten Bereiche (11) und dem benachbarten n-typdotierten Bereich (12) befindet.

2. Photonischer Demodulator (1) nach Anspruch 1, wobei die Zwischenelektroden (I1, I2) von der ersten Fläche (F1) in einem Abstand zwischen 5 nm und 50 nm beabstandet sind.

3. Photonischer Demodulator (1) nach Anspruch 1 oder 2, wobei die p-typdotierten Bereiche (11) eine Tiefe ($P_M$) ab der ersten Fläche (F1) aufweisen, die größer ist als eine Tiefe ($P_C$) der n-typdotierten Bereiche (12).

4. Photonischer Demodulator (1) nach einem der Ansprüche 1 bis 3, wobei sich die p-typdotierten Bereiche (11) in der Hauptebene in der Nähe des zentralen Bereichs (Zc) befinden und die n-typdotierten Bereiche (12) davon entfernt sind.

5. Photonischer Demodulator (1) nach einem der Ansprüche 1 bis 4, wobei die p-typdotierten Bereiche (11) erste Halbleiterabschnitte (11a) sind, die sich in ersten Aussparungen (25) des Erfassungsabschnitts (10) befinden.

6. Photonischer Demodulator (1) nach einem der Ansprüche 1 bis 5, wobei die n-typdotierten Bereiche (12) erste Halbleiterabschnitte (12a) sind, die sich in zweiten Aussparungen (26) des Erfassungsabschnitts (10) befinden.

7. Photonischer Demodulator (1) nach einem der Ansprüche 1 bis 6, wobei der Erfassungsabschnitt (10) auf Germaniumbasis hergestellt ist.

8. Photonischer Demodulator (1) nach einem der Ansprüche 1 bis 7, mit einem umlaufenden Seitenabschnitt (24), der den Erfassungsabschnitt (10) in der Hauptebene umgibt, der aus einem Halbleitermaterial auf Siliziumbasis hergestellt ist.

9. Photonischer Demodulator (1) nach Anspruch 7 und 8, wobei der Erfassungsabschnitt (10) einen seitlichen Bereich (14) auf Basis von SiGe aufweist, der sich an der Schnittstelle mit dem peripheren seitlichen Abschnitt (24) befindet.

10. Herstellungsverfahren eines photonischen Demodulators (1) nach einem der vorhergehenden Ansprüche, das folgende Schritte umfasst:

    o Ausführung des Erfassungsabschnitts (10) aus einem nicht absichtlich dotierten Material;
    o Ausführung der p-typdotierten Bereiche (11) und der n-typdotierten Bereiche (12) in dem Erfassungsabschnitt (10);

o Ablagerung einer dielektrischen Passivierungsschicht auf dem Erkennungsabschnitt (10);
o Herstellung von Modulationselektroden, Sammelelektroden und Zwischenelektroden.

11. Herstellungsverfahren nach Anspruch 10, wobei die p-typdotierten Bereiche (11) eine Tiefe ($P_M$) ab der ersten Fläche (F1) aufweisen, die größer ist als die Tiefe ($P_C$) der n-typdotierten Bereiche (12).

12. Herstellungsverfahren nach Anspruch 10 oder 11, wobei die Herstellung der p-typdotierten Bereiche (11) folgende Schritte umfasst:

o Ausführung erster Aussparungen (25) in dem Erfassungsabschnitt (10) von der ersten Seite (F1) aus;
o Herstellung erster p-typdotierter Halbleiterabschnitte (11a), die mit einem Wachstumsdoppler versehen sind, durch Epitaxie in den ersten Aussparungen (25).

13. Herstellungsverfahren nach einem der Ansprüche 10 bis 12, wobei die Herstellung der n-typdotiertendotierten Bereiche (11) folgende Schritte umfasst:

∘ Ausführung zweiter Aussparungen (26) im Erfassungsabschnitt (10) von der ersten Seite (F1) aus;
∘ Herstellung zweiter p-typdotierter Halbleiterabschnitte (12a), die mit einem Wachstumsdoppler versehen sind, durch Epitaxie in den zweiten Aussparungen (26).

14. Herstellungsverfahren nach den Ansprüchen 12 und 13, wobei die ersten Aussparungen (25) eine Tiefe ($P_M$) aufweisen, die größer ist als die Tiefe ($P_C$) der zweiten Aussparungen (26).

**Claims**

1. Current-assisted photonic demodulator (1) adapted to detect light radiation of interest, comprising:

∘ a detection portion (10), extending vertically between a first face (F1) and a second face (F2) both parallel to a main plane, and comprising:

• at least two p-doped regions (11), intended to generate and modulate a drift current in the detection portion (10), lying flush with the first face (F1) and located on either side of a central zone (Zc) of the first face F1;
• at least two n-doped regions (12), adapted to collect the minority charge carriers photogenerated during the absorption of the light radiation of interest in the detection portion (10), lying flush with the first face (F1) and located adjacent to the p-doped regions (11);

∘ a dielectric passivation layer (2), made of an electrically insulating material, and covering the first face (F1);
∘ modulation electrodes (M1, M2), passing through the dielectric passivation layer (2) and in contact with the p-doped regions (11); and collection electrodes (C1, C2), passing through the dielectric passivation layer (2) and in contact with the n-doped regions (12);
∘ **characterised in that** it comprises intermediate electrodes (I1, I2), intended to be negatively biased, partly passing through the dielectric passivation layer (2) and spaced apart from the first face (F1) by a non-zero distance, each being located, in projection onto the main plane, between one of the p-doped regions (11) and the adjacent n-doped region (12).

2. Photonic demodulator (1) according to claim 1, wherein the intermediate electrodes (I1, I2) are spaced apart from the first face (F1) by a distance of between 5 nm and 50 nm.

3. Photonic demodulator (1) according to claim 1 or 2, wherein the p-doped regions (11) have a depth ($P_M$) from the first face (F1) greater than a depth ($P_C$) of the n-doped regions (12).

4. Photonic demodulator (1) according to any one of claims 1 to 3, wherein the p-doped regions (11) are located, in projection onto the main plane, in proximity to the central zone (Zc), and the n-doped regions (12) being distant therefrom.

5. Photonic demodulator (1) according to any one of claims 1 to 4, wherein the p-doped regions (11) are first semiconductor portions (11a) located in first indentations (25) in the detection portion (10).

6. Photonic demodulator (1) according to any one of claims 1 to 5, wherein the n-doped regions (12) are first semiconductor portions (12a) located in second indentations (26) in the detection portion (10).

7. Photonic demodulator (1) according to any one of claims 1 to 6, wherein the detection portion (10) is made of a material based on germanium.

8. Photonic demodulator (1) according to any one of claims 1 to 7, comprising a peripheral lateral portion (24) surrounding the detection portion (10) in the main plane, made of a semiconductor material based on silicon.

9. Photonic demodulator (1) according to claims 7 and 8, wherein the detection portion (10) includes a lateral zone (14) made of a material based on SiGe, located at the interface with the peripheral lateral portion (24).

10. Method for manufacturing a photonic demodulator (1) according to any one of the preceding claims, comprising the following steps:

   ◦ producing the detection portion (10) from a not intentionally doped material;
   ◦ producing p-doped regions (11) and n-doped regions (12) in the detection portion (10);
   ◦ depositing a dielectric passivation layer on the detection portion (10);
   ◦ producing modulation electrodes, collection electrodes and intermediate electrodes.

11. Manufacturing method according to claim 10, wherein the p-doped regions (11) have a depth ($P_M$) from the first face (F1) greater than the depth ($P_C$) of the n-doped regions (12).

12. Manufacturing method according to claim 10 or 11, wherein producing the p-doped regions (11) comprises the following steps:

   ◦ producing first indentations (25) in the detection portion (10) as from the first face (F1);
   ◦ producing by epitaxy, in the first indentations (25), first semiconductor portions (11a) p-doped by growth.

13. Manufacturing method according to any one of claims 10 to 12, wherein producing the n-doped regions (11) comprises the following steps:

   ◦ producing second indentations (26) in the detection portion (10) as from the first face (F1);
   ◦ producing by epitaxy, in the second indentations (26), second semiconductor portions (12a) n-doped by growth.

14. Manufacturing method according to claims 12 and 13, wherein the first indentations (25) have a depth ($P_M$) greater than the depth ($P_C$) of the second indentations (26).

Fig.1A

Fig.1B

Fig.1C

**Fig.2A**

**Fig.2B**

**Fig.2C**

Fig.3A

Fig.3B

Fig.3C

**Fig.4A**

**Fig.4B**

**Fig.4C**

**Fig.4D**

**Fig.4E**

**Fig.4F**

**Fig.4G**

**Fig.4H**

**Fig.4I**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE VAN NIEUWENHOVE et al.** Novel Standard CMOS Detector using Majority Current for giding Photo-Generated Electrons towards Detecting Junctions. *Proc. Symp. IEEE/LEOS Benelux Chapter*, 2005, 229-232
- **DALLA BETTA et al.** Design and Characterization of Current-Assisted Photonic Demodulators in 0.18-$\mu$m CMOS Technology. *IEEE Trans. Electron Devices*, June 2011, vol. 58 (6), 1702-1707

- **HARTMANN ; AUBIN**. Assessment of the growth/etch back technique for the production of Ge strain-relaxed buffers on Si. *Journal of Crystal Growth*, 2018, vol. 488, 43
- **REBOUD et al.** Structural and optical properties of 200mm germanium-on-insulator (GeOI) substrates for silicon photonics applications. *Proc. SPIE 9367, Silicon Photonics X*, 27 February 2015, 936714